# EUROPÄISCHE PATENTSCHRIFT

(11) **EP 2 622 112 B1**
(45) Veröffentlichungstag und Bekanntmachung des Hinweises auf die Patenterteilung: **07.01.2015**
(21) Anmeldenummer: 12791755.7
(22) Anmeldetag: 27.11.2012
(51) Int. Cl.: C23C 14/24, C23C 14/26, C23C 14/22

(54) **VORRICHTUNG UND VERFAHREN ZUM VERDAMPFEN VON MATERIAL AUS EINER METALLSCHMELZE**
APPARATUS AND PROCESS FOR EVAPORATION OF MATERIAL FROM A METAL MELT
DISPOSITIF ET PROCÉDÉ DE VAPORISATION D'UN MATÉRIAU À PARTIR DE MÉTAL EN FUSION

(30) Priorität: 21.12.2011 DE 102011089501
(43) Veröffentlichungstag der Anmeldung: 07.08.2013
(73) Patentinhaber: Freiberger Compound Materials GmbH, 09599 Freiberg (DE)
(72) Erfinder: LUKIN, Gleb, 09111 Chemnitz (DE); PÄTZOLD, Olf, 09623 Frauenstein (DE); STELTER, Michael, 09600 Wegefahrt (DE)
(74) Vertreter: Prüfer & Partner GbR European Patent Attorneys
(86) Internationale Anmeldenummer: PCT/EP2012/073677
(87) Internationale Veröffentlichungsnummer: WO 2013/092124

(56) Entgegenhaltungen:
- EP-A1- 1 967 604
- JP-A- 58 197 270
- JP-A- 2005 336 558
- US-A- 4 125 086

## Beschreibung

Die Erfindung betrifft eine induktiv geheizte Vorrichtung zum thermischen Verdampfen von Material aus einer Schmelze mit hoher elektrischer Leitfähigkeit (nachfolgend Metallschmelze oder metallische Schmelze) sowie ein entsprechendes Verfahren. Die Vorrichtung kann als Materialquelle zur Herstellung von Beschichtungen und Materialien in einem weiten Druckbereich vom Hochvakuum bis hin zu Atmosphärendruck verwendet werden. Bei dem Material der Metallschmelze kann es sich insbesondere auch um die niedrig schmelzenden Metalle, wie z.B. Gallium, Indium, Aluminium oder Mischungen derselben handeln.

Die thermische Verdampfung von metallischen Schmelzen besitzt ein breites industrielles Anwendungsspektrum, das von der Herstellung von Funktionsbeschichtungen bis zur Materialsynthese aus der Gasphase reicht (S. Shah et al., "Evaporation: processes, bulk microstructures and mechanical properties", In: "Handbook of deposition technologies for films and coatings", Ed. P. Martin, pp. 135-252, William Andrew, Oxford, 2010, ISBN 978-0-8155-2031-3).

Durch induktives Heizen der Schmelze können Temperaturen größer als 2000°C erzielt werden, vgl. A. Kuzmichev, L. Tsybulsky, "Evaporators with induction heating and their applications", In: "Advances in induction and microwave heating of mineral and organic materials", Ed. S. Grundas, pp. 269-302, InTec, Rijeka; Croatia, 2011, ISBN 978-953-307-522-8 , wodurch hohe Verdampfungsraten erreichbar sind. Selbst bei Metallen mit niedrigem Dampfdruck, wie z.B. Gallium kann durch Induktionsheizung eine effiziente thermische Verdampfung gewährleistet werden, J. E. Mahan, "Physical vapor deposition of thin films", pp. 143-144, Wiley, 2000, ISBN 0-471-33001-9.

Verdampfungsvorrichtungen werden überwiegend unter Hochvakuumbedingungen eingesetzt (S. Shah et al., *a.a.O.*; A. Kuzmichev et al. (2011), *a.a.O.*)*,* wobei die Molekularströmung den dominierenden Transportmechanismus für die verdampften Spezies darstellt. Bei bestimmten Verfahren zur Herstellung von Verbindungshalbleitern erfolgt die Verdampfung auch im Grobvakuum und der Transport in der Gasphase durch Konvektion und Diffusion (vgl.: Yu. A. Vodakov et al., "High rate GaN epitaxial growth by sublimations sandwich method", J. Crys. Growth 183 (1998) 10; E. Berkman, PhD Thesis, North Carolina State University, 2005; M. Imade et al., Mat. Lett. 59 (2005) 4026 ; H. Wu et al., phys. stat. sol. (c) 7 (2005) 2032 ; D. Siche et al., J. Crys. Growth 310 (2008) 916.

Der Induktor kann unmittelbar am Schmelztiegel (vg.: I. Ames et al., "Crucible type evaporation source for aluminum", Rev. Sci. Instr., 37 (1966) 1737; R. R. Phinney, D. C. Strippe, "Crucible for evaporation of metallic film", US 4,791,261; A. Kuzmichev, L. Tsybulsky, "Evaporators with induction heating and their applications", Przeglad elektrotechniczny, 84 (2008) 32) oder außerhalb der Reaktionskammer, die meist aus einem nicht leitenden, temperaturbeständigen Material, z.B. Quarzglas (Yu. A. Vodakov et al., *a.a.O.*) besteht, positioniert werden. Im zweiten Fall wird die Kontamination des Systems durch den Induktor sowie chemische Reaktionen zwischen dem Induktor und einem ggf. vorhandenen Prozessgas vermieden. Somit erlaubt eine Konfiguration mit außerhalb angeordnetem Induktor den Einsatz von reaktiven Gasen im System, wie z. B. Ammoniak bei der Herstellung von Nitriden (vgl. Yu. A. Vodakov et al., *a.a.O.*; E. Berkman, *a.a.O*; Imade et al., *a.a.O.*; H. Wu et al., *a.a.O*)*,* während für die Vakuumverdampfung auch die Variante mit innen liegendem Induktor relevant ist (vgl. I. Ames et al., *a.a.O.*; R.R. Phinney et al., *a.a.O.*; A. Kuzmichev et al (2008), *a.a.O.*).

Die Verdampfungstemperatur kann durch direkte oder indirekte, elektro-magnetische Kopplung zwischen der Schmelze und Induktor eingestellt werden. Im ersten Fall wird die Wärme bei minimalen Verlusten direkt in der Schmelze induziert. Durch starke Lorentzkräfte entsteht dabei jedoch häufig eine instabile hydrodynamische Situation, die z.B. mit dem Auftreten von irregulären Fluktationen der Schmelzoberfläche (A. Kuzmichev et al. (2011), *a.a.O*.) oder sogar mit der Emission von Schmelztropfen in die Gasphase ( A. Kuzmichev et al. (2011), *a.a.O.*) verbunden ist und sich damit nachteilig auf den Verdampfungsprozess auswirkt. Die indirekte Variante basiert auf der Einkopplung der Wärme in einem bei Arbeitstemperatur festen Suszeptor. Der Suszeptor fungiert dabei entweder gleichzeitig als Schmelztiegel (I. Ames et al., *a.a.O*.) oder Suszeptor und Tiegel sind als separate Komponenten ausgeführt (R.R. Phinney et al., *a.a.0*.; A. Kuzmichev et al (2008), *a.a.O.*). Die Wärmeübertragung zur Schmelze erfolgt mittels Wärmeleitung und -Strahlung. Aufgrund der abschirmenden Wirkung des Suszeptors wird die Intensität der elektro-magnetisch induzierten Strömung in der Schmelze drastisch reduziert, was sich vorteilhaft auf die Stabilität der Verdampfung auswirkt (A. Kuzmichev et al. (2011), *a.a.O*.).

Kriterien für die Auswahl des Suszeptormaterials sind ein hoher Schmelzpunkt und eine hohe elektrische Leitfähigkeit sowie eine hohe Temperaturwechselbeständigkeit und möglichst inertes Verhalten gegenüber der im konkreten Einsatzfall vorliegenden Schmelze und Gasatmosphäre. Bevorzugtes Material ist Graphit (R.R. Phinney et al., *a.a.O*.; A. Kuzmichev et al (2008), *a.a.O.*), teilweise kommen auch leitfähige Spezialkeramiken (I. Ames et al., *a.a.O*.) oder Molybdän (R.R. Phinney et al., *a.a.O.*) zum Einsatz. Ein wesentlicher Nachteil bei der Verwendung eines Suszeptors ist, dass dieser unabhängig vom Material und von der Ausführungsform immer eine signifikante Verunreinigungsquelle im System darstellt.

JP 2005-336558 A beschreibt ein Verdampfungssystem das einen Tiegel mit einer äußeren und einer inneren Tiegelkammer umfasst. Aus einer Zuführkammer innerhalb der gleichen Vakuumkammer wird der äußeren Tiegelkammer Rohmaterial zugeführt. Das Rohmaterial umfasst eine fluoreszierende Substanz, in der Alkalimetalle, Erdalkalimetalle oder Übergangsmetalle in Halogenverbindungen vorliegen. Die äußere Tiegelkammer und die innere Tiegelkammer sind durch Öffnungen miteinander verbunden. Das in die äußere Tiegelkammer über die Zuführleitung eingebrachte Rohmaterial wird durch eine Hochfrequenzspule erhitzt und aufgeschmolzen und fließt infolgedessen in die innere Tiegelkammer nach, wo es verdampft und durch eine Öffnung im Deckel entweicht. Auf einem in der Vakuumkammer angebrachten Substrat wird das verdampfte Rohmaterial als dünner Film abgeschieden. Der Film dient zur Belichtung von Röntgen-, Beta- oder Gammstrahlenbildern im Medizinbereich.

Es ist eine Aufgabe der Erfindung, ein verbessertes Verfahren sowie eine entsprechende Vorrichtung für das Verdampfen einer Metallschmelze anzubieten.

Diese und weitere Aufgaben der Erfindung werden gelöst durch eine Vorrichtung zum Verdampfen eines Metalls aus einer Schmelze mit den Merkmalen des Anspruchs 1 (Vorrichtung) sowie durch ein entsprechendes Verfahren mit den Merkmalen des Anspruchs 11 (Verfahren). Bevorzugte Ausgestaltungen der Erfindung sind den abhängigen Ansprüchen zu entnehmen.

Ein Aspekt der Erfindung sieht eine Vorrichtung vor, die einen ersten Tiegel oder Tiegelbereich sowie einen zweiten Tiegel oder Tiegelbereich umfasst. Der erste Tiegel oder Tiegelbereich ist zur Aufnahme der zu verdampfenden Metallschmelze vorgesehen, der zweite Tiegel oder Tiegelbereich ist zur Aufnahme eines Suszeptormaterials vorgesehen. Der erste Tiegel oder Tiegelbereich und der zweite Tiegel oder Tiegelbereich definieren voneinander räumlich verschiedene Innenräume - einer zur Aufnahme der Metallschmelze und der andere zur Aufnahme des Suszeptormaterials - wobei diese Innenräume gemäß einer Ausführungsform voneinander getrennt, gemäß einer anderen Ausführungsform aber auch miteinander verbunden sein können (z.B. nach Art eines Siphons).

Unter dem Begriff Tiegel ist hier ein eigenständiger Behälter zu verstehen, während der Begriff Tiegelbereich einen tiegel- oder behälterartigen Abschnitt einer zusammenhängenden Anordnung bezeichnet, die auch aus einer Vielzahl von Einzelkomponenten oder -wänden zusammengesetzt sein kann. Insbesondere kann bei diesem Aspekt eine solche gemeinsame Anordnung die zwei oder mehr Tiegelbereiche umfassen.

Bei der Metallschmelze kann es sich um die Schmelze eines beliebigen Stoffs, insbesondere eines Metalls, handeln. Besonders vorteilhafte Ausführungsformen werden im Hinblick auf eine Eignung des Tiegel oder Tiegelbereichs (bzw. der Tiegel oder der Tiegelbereiche) für Schmelzen aus Gallium, Indium und/oder Aluminium erreicht. Die Eignung beinhaltet unter anderem die entsprechende chemische, Wärme- und/oder mechanische Druckbeständigkeit des Tiegel- oder Tiegelbereichs gegenüber diesen Stoffen.

Das Suszeptormaterial besitzt die Eigenschaft, einwirkende elektromagnetische Strahlung über Induktion in Wärme umzuwandeln. Bei dem Suszeptormaterial handelt es sich um die schmelzflüssige Phase des gleichen oder zumindest eines ähnlichen Materials wie dasjenige der zu verdampfenden Metallschmelze.

Die durch Induktion in Wärme umzuwandelnde elektromagnetische Strahlung wird durch eine aufgrund dieser Wirkung so bezeichnete Heizungsquelle erzeugt. Bei der zu erzeugenden elektro-magnetischen Strahlung handelt es sich insbesondere um eine für diese Zwecke und vorzugsweise an das Suszeptormaterial angepasste geeignete Radiofrequenz- oder Mikrowellenstrahlung, z.B. aus dem Frequenzbereich zwischen 0,1 kHz und 300 GHz, andere - insbesondere angrenzende - Wellenlängenbereiche sind aber gemäß den Ausführungsformen nicht ausgeschlossen.

Die Heizungsquelle ist nun derart in Bezug auf den ersten Tiegel oder Tiegelbereich und den zweiten Tiegel oder Tiegelbereich angeordnet, dass sie das Suszeptormaterial in dem zweiten Tiegel oder Tiegelbereich aufgrund elektromagnetischer Induktion aufheizt, während sich die Metallschmelze in dem ersten Tiegel oder Tiegelbereich nicht oder nur unerheblich aufheizt. "Unerheblich" bedeutet hier, dass die Heizung der Metallschmelze aufgrund der elektromagnetischen Induktion unmittelbar durch die Heizungsquelle nicht ausreicht, um den Verdampfungsprozess zu erreichen oder zumindest aufrecht zu erhalten.

Eine Wirkung dieser Anordnung besteht demnach darin, dass der erste Tiegel oder Tiegelbereich (oder genauer: die darin enthaltene Metallschmelze) beispielsweise durch den zweiten Tiegel oder Tiegelbereich (oder genauer: durch das darin enthaltene Suszeptormaterial) oder andere Mittel von der Einwirkung der elektromagnetischen Strahlung bzw. Induktion abgeschirmt wird. Die gegenseitige Anordnung der beiden Tiegel bzw. Tiegelbereiche in bezug auf die Heizungsquelle spielt hierbei eine Rolle, sowie der Effekt, dass die eingesetzte elektromagnetische Strahlung dabei eine nur begrenzte Eindringtiefe besitzt.

Die für die Verdampfung erforderliche Wärmezufuhr wird über eine thermische Kopplung zwischen den ersten und zweiten Tiegeln oder Tiegelbereichen bewerkstelligt.

Es wurde herausgefunden, dass durch diese Ausführungsform ein ansonsten auftretendes Spritzen der Metallschmelze an deren Oberfläche vermieden werden kann, das stattfinden würde, wenn die Metallschmelze direkt der magnetischen Induktion ausgesetzt wäre.

In dem speziellen Beispiel einer Gallium-, Indium und/oder Aluminiumschmelze kann folglich die unerwünschte Bildung von Tröpfchen zumindest reduziert, wenn nicht sogar ganz vermieden werden.

Bei dem erfindungsgemäßen Verfahren wird ein in einem zweiten Tiegel oder Tiegelbereich vorgesehenes Suszeptormaterial bereitgestellt und Wärme durch induktives Heizen des Suszeptormaterials zugeführt. Ferner wird eine Metallschmelze bzw. ein entsprechendes noch nicht geschmolzenes Ausgangsmaterial in einem mit dem zweiten Tiegel oder Tiegelbereich durch thermische Kopplung verbundenen ersten Tiegel oder Tiegelbereich bereitgestellt. Die Wärme wird durch die thermische Kopplung von dem Suszeptormaterial in dem zweiten Tiegel oder Tiegelbereich auf die Metallschmelze in dem ersten Tiegel oder Tiegelbereich übertragen, so dass die Metallschmelze eine gewünschte Temperatur erreicht. Die Metallschmelze in dem ersten Tiegel oder Tiegelbereich wird bei der gewünschten Temperatur verdampft.

Nachfolgend wird die Erfindung anhand mehrerer Ausführungsbeispiele näher erläutert. Zur Illustration der Ausführungsbeispiele dienen folgende Abbildungen:
Fig. 1 zeigt einer erste Vorrichtung zum Verdampfen einer Metallschmelze.
Fig. 2 zeigt ein zweites Ausführungsbeispiel einer erfindungsgemäßen Vorrichtung zum Verdampfen einer Metallschmelze.
Fig. 3 zeigt ein perspektivisches Schnittbild der Vorrichtung gemäß dem zweiten Ausführungsbeispiel aus Fig. 2.
Fig. 4 zeigt eine dritte Vorrichtung zum Verdampfen einer Metallschmelze.
Fig. 5 zeigt ein viertes Ausführungsbeispiel einer erfindungsgemäßen Vorrichtung zum Verdampfen einer Metallschmelze.

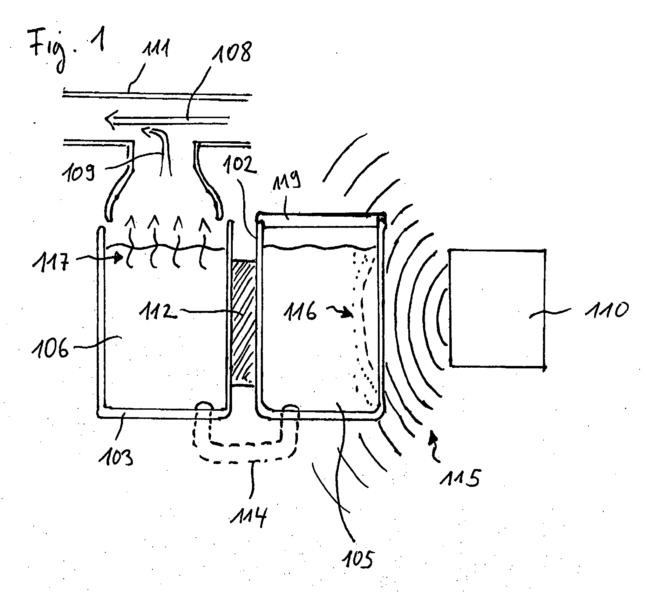

In Fig. 1 ist eine erste Vorrichtung zum Verdampfen einer Metallschmelze gezeigt. Sie umfasst einen ersten Tiegel 103 sowie einen zweiten Tiegel 102. Ferner ist eine Quelle 110 zum Aufheizen und Schmelzen des in dem zweiten Tiegel 102 befindlichen Materials (z.B. ein Pulver) vorgesehen, so dass eine Schmelze 105 entsteht. Bei dem Material kann es sich um ein beliebiges Metall handeln. Metalle enthaltende Gemische oder metallische Verbindungen seien hier ebenfalls von dem Begriff Metall umfasst. Bei dem Material der Schmelze 105 kann es sich einer speziellen Ausführungsform zufolge insbesondere auch um niedrig schmelzende Metalle wie z.B. Gallium, Indium, Aluminium oder Mischungen derselben etc. handeln.

Die Heizwirkung wird in diesem nicht einschränkenden Beispiel durch eine elektromagnetische Strahlung 115 bewirkt, wobei die Quelle 110 beispielsweise eine die Strahlung erzeugende Hochfrequenzspule aufweisen kann. Die Strahlung bzw. ihre Wellenlänge oder ihr Wellenlängenspektrum ist auf das Material der Metallschmelze 105 abgestimmt, so dass sich dieses über elektromagnetische Induktion aufheizt. Die Metallschmelze 105 dient hier entsprechend als Suszeptormaterial. Die Induktionsleistung kann durch eine Steuerung der Quelle 110 eingestellt werden. Die maximale Leistung reicht aus, das Metallmaterial zu schmelzen.

Der Tiegel kann beispielsweise aus einem nicht leitendem, thermisch und chemisch beständigen, wie z.B. pyrolytisch abgeschiedenes Bornitrid (pBN) oder anderen geeigneten Materialien gebildet sein, und ist hier durch einen Deckel 119 abgeschlossen, um ein Entweichen des verdampfenden Metallgases zu verhindern.

Der erste Tiegel 103 und der zweite Tiegel 102 sind über eine Wärmekopplung 112 thermisch miteinander gekoppelt. Es kann sich dabei um ein Material mit hoher Wärmeleitfähigkeit handeln, so dass eine Schmelze 106, die im ersten Tiegel 103 vorgesehen ist und beispielsweise auch das gleiche oder eines ähnlichen Material wie in der Schmelze 105 umfasst, insbesondere auch niedrig schmelzende Metalle wie z.B. Gallium, Indium, Aluminium oder Mischungen derselben etc., auf nahezu die gleiche Temperatur gebracht wird, wie die Metallschmelze 105 in dem zweiten Tiegel 102.

Andererseits findet kein oder nur ein unwesentlicher, vernachlässigbarer direkter Wärmeeintrag durch die Quelle 110 in das im ersten Tiegel 103 enthaltene Material 106 statt. Dies liegt daran, dass die Metallschmelze 105 im zweiten Tiegel 102 das Material oder die Metallschmelze 106 im ersten Tiegel von der elektromagnetischen Strahlung 115 abschirmt, welche den Wärmeeintrag über Induktion 116 bewirkt. Die Eindringtiefe in der Metallschmelze 116 ist dabei vergleichsweise gering, die Induktion bleibt im Wesentlichen oberflächlich.

Die Abschirmung tritt deshalb ein, weil der zweite Tiegel 102 von der Heizungsquelle 110 aus betrachtet räumlich vor dem ersten Tiegel 103 angeordnet ist und die die Induktion 116 bewirkende elektromagnetische Strahlung 115 von der Metallschmelze 105 im zweiten Tiegel 102 absorbiert wird.

Infolge der indirekten Erwärmung über die Wärmeleitung aus dem zweiten Tiegel vermittels der Wärmekopplung 112 wird der flüssige Zustand der Metallschmelze aufrecht erhalten, wobei das Metall aus der Schmelze verdampft, welches in Fig. 1 durch das Bezugszeichen 117 angedeutet ist.

Optional können die beiden Tiegel 103 und 102 auch durch eine Leitung 114 verbunden sein, die einem Austausch zwischen den beiden Schmelzen oder einem Nachfließen zum Ersatz verdampfter Schmelze im ersten Tiegel dienen kann. Am zweiten Tiegel kann dazu auch eine Nachfüllvorrichtung für das Material der Schmelze vorgesehen sein (nicht dargestellt).

Der Metalldampf bzw. das Metallgas 109 wird gemäß diesem Ausführungsbeispiel entweder aufgefangen und in einer Transportleitung 111 von einem Trägergas 108 mitgeführt, um im weiteren einer gewünschten Verwendung zugeführt zu werden oder im Vakuum als Partikelstrahl (ohne Transportleitung 111) abtransportiert.

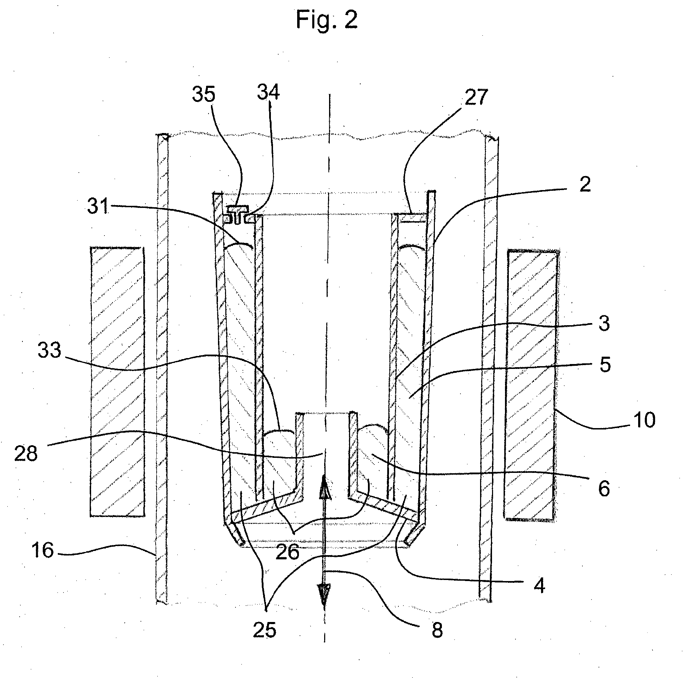

Fig. 2 zeigt in einer Querschnittsdarstellung ein zweites Ausführungsbeispiel einer Vorrichtung zum Verdampfen eines Metalls aus einer Schmelze mit Transport der verdampften Spezies in der Gasphase durch einen geeigneten Prozessgasstrom. Die für die hier vorgesehenen Schmelzen 5, 6 vorgesehenen Materialien entsprechen denjenigen des ersten Ausführungsbeispiels.

Die Vorrichtung befindet sich in einem Quarzglasreaktor 16, der mit einem Vakuumsystem (nicht gezeigt) verbunden ist, mit welchem ein definierter Arbeitsdruck zwischen 1 und 1000 mbar eingestellt werden kann. Die Erfindung ist aber keines falls auf solche Druckbereiche begrenzt und höhere Drücke sind ebenso möglich.

Die Vorrichtung umfasst ein konzentrisch angeordnetes, zylindrisches DoppelkammerTiegelsystem in vertikaler Aufstellung mit einem ersten Tiegelbereich 26 und einem zweiten Tiegelbereich 25. Der zweite Tiegelbereich 25 umschließt den ersten Tiegelbereich 26 zylindermantelförmig und schirmt ihn nach außen ab. Der erste Tiegelbereich 26 umschließt einen Kanal 28, der sich entlang der in diesem speziellen Beispiel vertikalen Symmetrieachse der Vorrichtung erstreckt. Der erste Tiegelbereich 26 ist mit dem Kanal 28 über eine Öffnung verbunden, um das verdampfte Material abgeben zu können. Im Beispiel besteht die Öffnung in einem ringförmigen Gebiet des nach oben hin offenen ersten Tiegelbereichs 26. Die Öffnungen können selbstverständlich auch seitlich gerichtet sein. Außerdem kann der Durchmesser der Öffnungen von außen steuerbar eingerichtet sein.

Der erste, innere Tiegelbereich 26 wird in diesem Ausführungsbeispiel durch die Wand eines nach unten geöffneten, trichterförmigen Elements 4 und durch die innere Wand 3 des zweiten, äußeren Tiegelbereiches 25 gebildet. Der Tiegel kann wiederum aus einem nicht leitendem, thermisch und chemisch beständigen, wie z.B. pBN oder anderen geeigneten Materialien bestehen.

Der erste Tiegelbereich 26 enthält die zu verdampfende Metallschmelze 6. Durch eine geeignete Nachfülleinrichtung, z.B. eine Kapillare (nicht in Fig. 2 gezeigt) kann verdampftes Material in fester (z.B. Pulver) oder flüssiger Form nachgefüllt werden. Die Nachfüllung kann einer speziellen Modifikation zufolge geregelt erfolgen, wobei z.B. anhand eines Gewichtssensors das Gewicht des dargestellten Doppelkammer-Tiegelsystems überwacht wird (nicht in Fig. 2 gezeigt).

Der zweite Tiegelbereich 25 wird durch das Tiegelelement 3 (Innenwand), durch den sich aufweitenden Teil des umgedrehten trichterförmigen Elements 4 (Boden) und durch einen äußeren Tiegel 2 (Außenwand) gebildet. Die den ersten und zweiten Tiegelbereichen 25, 26 gemeinsame Wand 3 kann Öffnungen enthalten (nicht dargestellt), um einen Materialaustausch zwischen den beiden Tiegelbereichen zu ermöglichen. Die Öffnungen können insbesondere im unteren Bereich der Tiegel oder Tiegelbereiche nach Art eines Siphons ausgebildet sein , wobei dann die Schmelzoberflächen in den beiden Tiegeln gleich hoch sind..

Im zweiten Tiegelbereich 25 ist eine gleiche oder eine ähnliche Metallschmelze (Suszeptor 5, beispielsweise ein ähnlich niedrig schmelzendes Metall) wie im inneren Tiegelbereich 26 eingebracht. Der zweite Tiegelbereich 25 ist im oberen Bereich durch einen Deckel 27 verschlossen, um das Verdampfen des Materials zu verhindern. Für Nachfüll- oder Messzwecke befindet sich im Deckel die Bohrung 34, die ansonsten mit der Schraube 35 verschlossen ist.

Im Bereich des Doppelkammer-Tiegelsystems 25, 26 ist außerhalb des Quarzglas-Reaktors 16 eine Heizungsquelle 10 in Form einer Hochfrequenzspule angeordnet. Die Spule (Heizungsquelle 10) erzeugt eine auf die Metallschmelze des äußeren Tiegelbereiches 25 abgestimmte Strahlung, so dass diese durch Induktion erhitzt werden kann. Die Metallschmelze im äußeren Tiegelbereich 26 wirkt damit als Suszeptor 5 für die elektro-magnetische Strahlung.

Die Dicke des Suszeptors, d.h. der innere Abstand zwischen den Tiegelelementen 2 und 3 des äußeren Tiegelbereiches ist größer als die Eindringtiefe der elektromagnetischen Strahlung der Hochfrequenzspule (Heizungsquelle 10). Damit wird gewährleistet, dass die Metallschmelze 6 im inneren Tiegelbereich 26 nicht oder nicht wesentlich durch die Strahlung der Spule beeinflusst wird.

Die Schmelze 6 im inneren Tiegelbereich 26 wird vielmehr durch Wärmeleitung aus dem zweiten Tiegelbereich 25 über die Wand des Tiegelelements 3 geheizt. Durch die konzentrische Anordnung der Tiegelbereiche ist die Grenzfläche zwischen den Tiegelbereichen 25, 26 im Verhältnis zum Volumeninhalt besonders groß, was eine effiziente Wärmeübertragung begünstigt.

Für die Angleichung der Temperaturen in den Metallschmelzen 5 und 6 muss das Tiegelmaterial des Tiegelelementes 3 die Wärmeübertragung ermöglichen, was z.B. bei der Verwendung von pBN gegeben ist. Die Erfindung ist aber nicht auf diese Materialauswahl beschränkt.

Die Temperatur in der Metallschmelze (Suszeptormaterial 5) und/oder in der Metallschmelze 6 kann mit Hilfe von Thermoelementen (in Fig. 2 nicht gezeigt) bestimmt werden, die einer Abwandlung des Ausführungsbeispieles zufolge zusammen mit der Heizungsquelle 10 einen Regelkreis bildet, um die Schmelze auf einer gewünschten Temperatur zu halten.

Ein Vorteil entsteht bei diesem Aufbau dadurch, dass negative Auswirkungen der mit der Induktionsheizung verbundenen elektromagnetischen Felder, wie das Spritzen bzw. die Tröpfchenbildung an der Oberfläche einer Schmelze, auf den äußeren, abgeschlossenen Tiegelbereich 25 beschränkt bleiben. Die Metallschmelze im inneren Tiegelbereich 26 kann dagegen ohne Tröpfchenbildung stabil und homogen verdampfen, was eine wesentliche Voraussetzung für eine verbesserte Qualität der nachfolgenden Prozesse darstellt.

Ein weiterer Vorteil bei diesem Aufbau entsteht dadurch, dass der Suszeptor 5 als wesentliche Kontaminationsquelle im System entfällt, was ebenfalls eine wesentliche Voraussetzung für eine verbesserte Qualität der nachfolgenden Prozesse darstellt.

Der vom Tiegelelement 4 des inneren Tiegels begrenzte zentrale Kanal 28 wird vom Trägergas 8 durchströmt. Das Trägergas 8 dient der Einstellung des Gesamtdruckes im Reaktor 16 sowie dem Transport und der Verdünnung der aus dem Schmelzvorrat 33 des inneren Tiegelbereiches 26 verdampften Metallspezies in der Gasphase.

Das Trägergas 8 kann aus einem beliebigen Inertgas, z.B. Argon, Wasserstoff, Stickstoff oder geeigneten Mischungen von Inertgasen gebildet sein. Je nach Strömungsrichtung des Trägergases 8 axial nach oben oder nach unten werden die verdampften Metallspezies nach oben oder nach unten aus dem Bereich des Tiegelsystems heraus transportiert. Die möglichen Strömungsrichtungen des Trägergases 8 sind in Fig. 2 durch den Doppelpfeil angedeutet

Neben dem Gesamtdruck im Reaktor stellt der Trägergasfluss 8 einen weiteren wesentlichen Parameter für die flexible Einstellung der Transportrate und -richtung der verdampften Metallspezies im System dar.

Die Trichterform des den Kanal 28 begrenzenden Tiegelelementes 4 ermöglicht zusammen mit einer geeignet gewählten, konstanten Strömungsgeschwindigkeit eine im Wesentlichen wirbelfreie Trägergasströmung und damit einen stationären Transport der verdampften Metallspezies mit konstanter Transportrate, was wiederum eine wesentliche Voraussetzung für eine verbesserte Qualität der nachfolgenden Prozesse darstellt.

Die Vorrichtung gemäß dem zweiten Ausführungsbeispiel ist jedoch nicht auf die in Fig. 2 gezeigte Geometrie des Tiegelelementes 4 beschränkt. Andere Geometrien sind ebenfalls möglich, sofern dadurch der laminare Charakter der Gasströmung 8 erhalten bleibt.

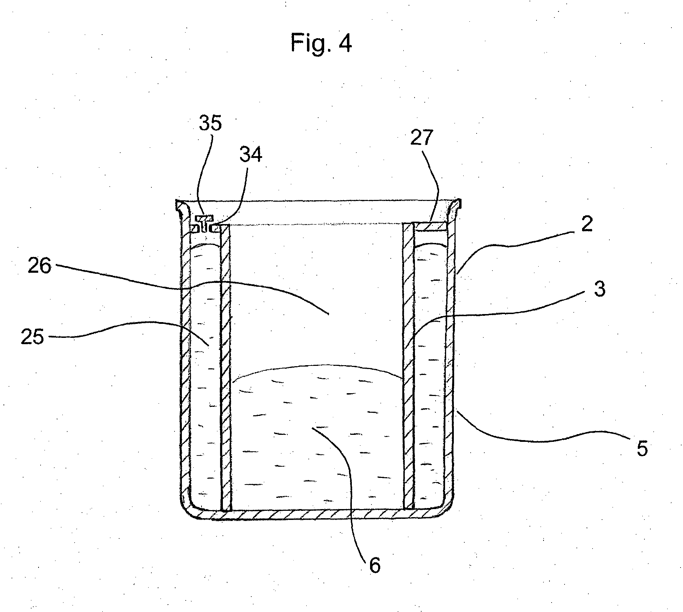

Die Vorrichtung gemäß dem zweiten Ausführungsbeispiel ist ferner nicht auf die Verwendung eines Trägergases beschränkt. Die Verdampfung der Metallschmelze im Hochvakuum ist ebenfalls möglich. Dann ist jedoch der zentrale Kanal 28 ohne Funktion, weshalb in diesem Fall die Verwendung der Vorrichtung in der unten beschriebenen dritten Ausführungsform (vgl. Fig. 4) vorzuziehen sein kann.

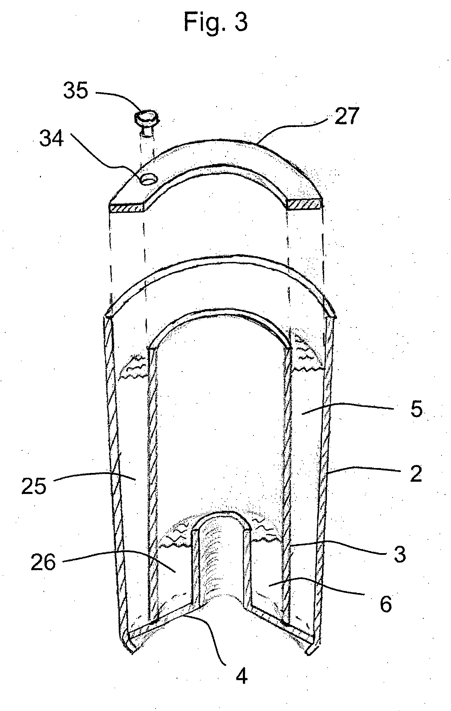

Fig. 3 zeigt eine perspektivische Ansicht des in Fig. 2 im Querschnitt dargestellten und vorstehend beschriebenen Doppelkammer-Tiegelsystems zur Illustration der konzentrischen Anordnung der Tiegelelemente. Zu sehen ist der durch die Tiegelelemente 2, 3, 4 sowie durch den Deckel 27 mit Bohrung 34 begrenzte äußere Tiegelbereich 25, der die als Suszeptor 5 verwendete Schmelze enthält. Zu sehen ist weiterhin der durch die Tiegelelemente 3,4 begrenzte innere Tiegelbereich 26 mit der zu verdampfenden Metallschmelze 6. Das Tiegelelement 4 begrenzt außerdem den zentralen Kanal 28 für den axial aufwärts oder abwärts gerichteten Strom des Trägergases 8.

Für den Betrieb der Vorrichtung gemäß Fig. 2, 3 wird zunächst der äußere Tiegelbereich 25 (Suszeptor 5) mit einem geeigneten metallischen Material in Pulverform oder als Granulat befüllt. Der innere Tiegelbereich 26 (Verdampfungsquelle) wird mit dem zu verdampfenden Material ebenfalls in Pulverform oder als Granulat befüllt. Danach wird mittels Hochfrequenzspule (als Heizungsquelle 10) eine elektromagnetische Strahlung mit einer auf das Material im äußeren Tiegelbereich 25 angepassten Frequenz oder einem angepassten Frequenzbereich erzeugt. Durch die induzierte Wärme wird das Material bis über den Schmelzpunkt erhitzt, so dass der schmelzflüssige Suszeptor 5 entsteht. Die im äußeren Tiegelbereich 25 entstehende Wärme wird durch Wärmeleitung und -strahlung auf das Metall im inneren Tiegelbereich 25 transferiert, wodurch dieses gleichfalls bis über den Schmelzpunkt erhitzt und als Schmelze 6 vorliegt. Die Metallschmelze 6 wird teilweise verdampfen, wobei die Verdampfungsrate bzw. der Sättigungspartialdruck nach der Einstellung des Temperaturausgleichs zwischen den Tiegelbereichen 25, 26 durch die Temperatur der Suszeptorschmelze definiert wird. Die minimale Temperatur für den Betrieb der Vorrichtung wird durch die Schmelzpunkte der Materialien (Suszeptor 5, Metallschmelze 6) bestimmt. Die maximale Betriebtemperatur wird durch die thermische Stabilität des Tiegelmaterials bestimmt und liegt z.B. bei der Verwendung von pBN oberhalb von 2000°C. Parallel oder zeitversetzt zur Einstellung des Temperaturgleichgewichtes in der Vorrichtung wird die Strömung eines Trägergases 8 oder einer Trägergasmischung mit einem definierten Massefluss aus einer oder mehreren externen Gasquellen erzeugt und axial aufwärts oder abwärts durch zentralen Kanal 28 der Vorrichtung geleitet. Der im inneren Tiegelbereich 26 entstehende Metalldampf der Schmelze 6 vermischt sich durch Diffusionsprozesse mit dem Trägergas bzw. dem Trägergasgemisch. Schließlich wird der Metalldampf der Schmelze 6 infolge von Korivektionsprozessen in Abhängigkeit von der Richtung der Trägergas- 8 oder Trägergasgemischströmung entweder nach oben oder nach unten aus der Vorrichtung abtransportiert und einer weiteren Verwendung zugeführt. Für die weitere Verwendung zur Beschichtung und Materialsynthese ist ein stationärer Transport des Metalldampfes durch eine laminare Trägergasströmung wesentlich. Das kann durch eine Geschwindigkeit der Trägergasströmung im Bereich von 1 cm/s bis 100 cm/s bei einem Gesamtdruck im Reaktor im Bereich von 1 mbar bis 1000 mbar erreicht werden. Die Erfindung ist aber keines falls auf solche Druckbereiche begrenzt und höhere Drücke sind ebenso möglich.

Fig. 4 zeigt in einer Querschnittsdarstellung eine dritte Vorrichtung zum Verdampfen eines Metalls aus einer Schmelze mit Transport der verdampften Spezies unter Hochvakuumbedingungen.

Die Vorrichtung befindet sich in einer Vakuumkammer aus Edelstahl oder einem anderen vakuumfesten Material (nicht gezeigt), die mit einem Vakuumsystem (nicht gezeigt) verbunden ist, mit welchem ein Druck von weniger als 10⁻⁴ mbar eingestellt werden kann.

Die Vorrichtung umfasst ein konzentrisch angeordnetes, zylindrisches Doppelkammer-Tiegelsystem in vertikaler Aufstellung, welches analog zum zweiten Ausführungsbeispiel (Fig. 2,3) aus einem äußeren Tiegelbereich 26 mit der als Suszeptor fungierenden Schmelze 5 und einem inneren Tiegelbereich 25 mit der zu verdampfenden Metallschmelze 6 besteht.

Der äußere Tiegelbereich 26 wird in diesem Ausführungsbeispiel durch einen zylindrischen Tiegel mit geschlossenem Boden 2, durch ein beiderseits offenes, zylindrisches Tiegelelement 3 mit kleinerem Durchmesser als der Tiegel 2 und durch ein kreisförmiges Deckelelement 27 gebildet. Für Nachfüll- und Messzwecke enthält das Deckelelement eine Bohrung 34, die mit einer Schraube 35 verschlossen werden kann.

Der innere Tiegelbereich 25 wird durch das innere Tiegelelement 3 und den Boden des Tiegelelementes 2 seitlich und nach unten hin begrenzt. Der Aufbau der Heizung, d.h. der Spule als Heizungsquelle 10 (in Fig. 4 nicht gezeigt) entspricht der in Fig. 2 gezeigten Anordnung, wobei auch hier die Symmetrieachsen der Spule und der Tiegel bzw. Tiegelbereiche bevorzugt zusammenfallen können.

Die Heizung des Tiegelsystems bis hin zur Einstellung eines definierten Partialdrucks der aus der Metallschmelze 6 verdampften Spezies entspricht den im zweiten Ausführungsbeispiel (Fig. 2,3) ausführlich beschriebenen Prinzipien. Ferner gelten die für das zweite Ausführungsbeispiel gemachten Aussagen zur Auswahl der Materialien (Suszeptor 5, Schmelze 6) sowie für die Tiegelelemente uneingeschränkt auch für das hier beschriebene, dritte Ausführungsbeispiel.

Im Unterschied zum zweiten Ausführungsbeispiel (Fig. 2, 3) wird auf einen Trägergastrom in der Prozesskammer verzichtet. Das Tiegelsystem besitzt keinen zentralen Kanal, sondern ist nach unten durch den Boden des Tiegelelementes 2 begrenzt. Das verdampfte Metall wird unter Hochvakuumbedingungen durch die Molekularströmung aus dem Bereich der Verdampfungsquelle nach oben abtransportiert und der weiteren Verwendung zugeführt.

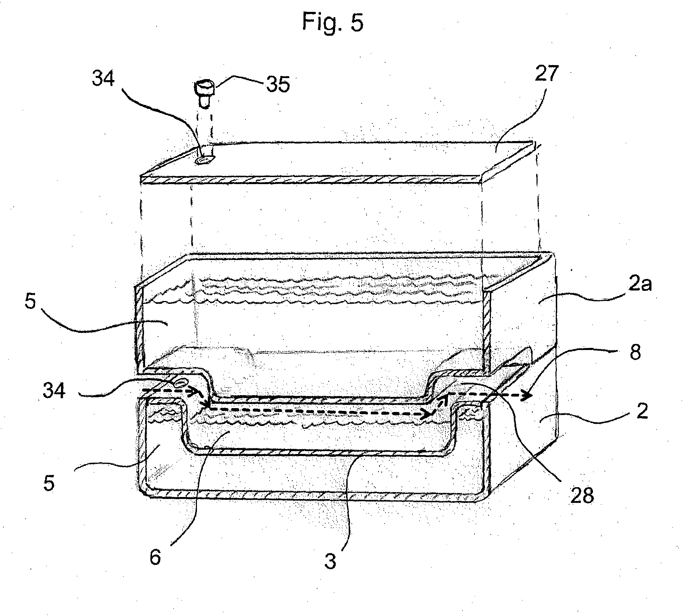

Fig. 5 zeigt in einer perspektivischen Darstellung ein viertes Ausführungsbeispiel einer Vorrichtung zum Verdampfen eines Metalls aus einer Schmelze in einer horizontalen Anordnung. Solche den vorhergehenden Ausführungsbeispielen ungefähr entsprechende Elemente sind hier mit gleichen Bezugszeichen versehen.

Die Vorrichtung befindet sich in einem Quarzglasreaktor (nicht gezeigt), der mit einem Vakuumsystem (nicht gezeigt) verbunden ist, mit welchem genau wie im zweiten Ausführungsbeispiel (Fig. 2, 3) ein definierter Arbeitsdruck zwischen 1 und 1000 mbar eingestellt werden kann. Die Erfindung ist aber keines falls auf solche Druckbereiche begrenzt und höhere Drücke sind ebenso möglich.

Die Vorrichtung umfasst ein horizontal angeordnetes Doppelkammer-Tiegelsystem, welches einen oberen Tiegelbereich und einen unteren Tiegelbereich umfasst.

Der obere Tiegelbereich wird in diesem Ausführungsbeispiel durch einen Behälter 2a mit einem rechteckigen Querschnitt und einem passenden Deckel 27 gebildet. Der untere Tiegelbereich wird durch einen weiteren Behälter 2 mit rechteckigem Querschnitt und einen passenden Deckel 3 gebildet. Die Deckelelemente 3, 27 enthalten Öffnungen 34 für Nachfüllzwecke, die mit Schrauben 35 verschlossen werden können. Im Fall des Deckelelementes 27 des oberen Behälters 2a kann die Öffnung 34 auch für die Temperaturmessung während des Prozesses benutzt werden.

Im Boden des oberen Tiegelbehälters 2a ist eine ausgedehnte Vertiefung ausgebildet, die einen Großteil der gesamten Bodenfläche umfasst. Im Deckelelement 3 des unteren Tiegelbehälters 2 ist eine zur Vertiefung des oberen Behälterbodens konforme Vertiefung ausgebildet.

Die Tiegelbehälter 2, 2a dienen der Aufnahme des Suszeptormaterials 5. Das zu verdampfende Metall (Metallschmelze 6) ist in der Vertiefung des Deckelelementes 3 des unteren Tiegelbehälters 2 eingebracht.

An den gegenüberliegenden Stirnflächen des oberen Tiegelbehälters 2a sind flache, rechteckige Aussparungen vorhanden, so dass sich bei der Anordnung der Tiegelelemente gemäß Fig. 5 ein flacher, horizontaler Kanal 28 mit rechteckigem Querschnitt zwischen dem oberen Tiegelbehälter 2a und unteren Tiegelbehälter 2 ergibt.

Der Kanal 28, der sich zwischen den gegenüberliegenden Stirnflächen des Tiegelsystems erstreckt, wird vom Trägergas 8 durchströmt. Durch den flachen Kanalquerschnitt wird eine große Kontaktfläche zwischen dem Trägergas und der zu verdampfenden Metallschmelze 6 bei gleichzeitig weitgehend laminarer Strömung des Trägergases 8 erreicht, wodurch ein effektiver und stationärer Transport der verdampften Metallspezies gewährleistet wird.

Im Übrigen gelten die für das zweite Ausführungsbeispiel (Fig. 2, 3) gemachten Aussagen im Hinblick auf die zu verwendenden Trägergase, die Druck- und Strömungsverhältnisse sowie die Transportmechanismen uneingeschränkt auch für das hier beschriebene, vierte Ausführungsbeispiel. Die in Fig. 5 nicht gezeigte Hochfrequenzspule als Heizungsquelle 10 besitzt eine (im Bezugssystem der Abbildung) vertikal verlaufende Symmetrieachse wie in den vorigen Ausführungsbeispielen. Alternativ kann sie aber auch in etwa mit der in Fig. 5 die Strömung des Trägergases 8 kennzeichnenden gestrichelten Linie zusammenfallen, d.h. die Spule umgibt den nicht dargestellten Quarzglasbehälter mit den darin angeordneten Behältern 2, 2a in der Abbildung horizontal liegend und quer zur Sichtrichtung.

Die Vorrichtung gemäß dem vierten Ausführungsbeispiel ist jedoch nicht auf die in Fig. 5 gezeigte Geometrie des Doppelkammer-Tiegelsystems beschränkt. Andere Behälter- und Kanalgeometrien sowie ggf. mehrere Kanäle sind ebenfalls möglich, sofern dadurch der laminare Charakter der Gasströmung des Trägergases 8 (bzw. des Trägergasgemisches) erhalten bleibt.

Die Vorrichtung gemäß dem vierten Ausführungsbeispiel ist ferner nicht auf die Verwendung eines Trägergases beschränkt. Die Verdampfung der Metallschmelze im Hochvakuum ist ebenfalls möglich.

Die Heizung des Tiegelsystems bis hin zur Einstellung eines definierten Partialdrucks der aus der Metallschmelze 6 verdampften Spezies entspricht den im zweiten Ausführungsbeispiel (Fig. 2, 3) ausführlich beschriebenen Prinzipien. Ferner gelten die für das zweite Ausführungsbeispiel gemachten Aussagen zur Auswahl der Materialen 5, 6 sowie für die Tiegelelemente uneingeschränkt auch für das hier beschriebene, vierte Ausführungsbeispiel.

## Patentansprüche

1. Vorrichtung zum Verdampfen einer Metallschmelze (6), umfassend:
einen ersten Tiegel oder Tiegelbereich (2, 2a; 26), welcher eingerichtet ist, die Metallschmelze (6, 106) aufzunehmen, umfassend wenigstens eine Öffnung, aus welcher das verdampfte Metall entweichen kann;
einen zweiten Tiegel oder Tiegelbereich (25, 102), welcher eingerichtet ist, ein Suszeptormaterial (5, 105) aufzunehmen;
eine Heizungsquelle (10), die angeordnet ist, so dass sie das Suszeptormaterial (5, 105) in dem zweiten Tiegel oder Tiegelbereich (25, 102) durch die Einwirkung elektromagnetischer Induktion aufheizt, wobei sie die Metallschmelze (6, 106) in dem ersten Tiegel oder Tiegelbereich (2, 2a; 26) dagegen nicht oder nur unerheblich aufheizt;
wobei der erste Tiegel oder Tiegelbereich (2, 2a; 26) und der zweite Tiegel oder Tiegelbereich (25, 102) thermisch gekoppelt sind, so dass die Metallschmelze (6, 106) eine gewünschte Temperatur annehmen kann,
wobei der erste Tiegel oder Tiegelbereich (2, 2a; 26) einen inneren Kanal (28) aufweist, zu welchem hin sich die wenigstens eine Öffnung erstreckt; wobei ferner eine Anordnung zur Bildung eines durch den Kanal (28) gerichteten Trägergasstroms (8) zur Mitnahme des aus der wenigstens einen Öffnung entwichenen, verdampften Metalls vorgesehen ist.

2. Vorrichtung nach Anspruch 1, wobei der erste Tiegel oder Tiegelbereich (2, 2a; 26) und der zweite Tiegel oder Tiegelbereich (25) eine gemeinsame Tiegelwand (3) besitzen.

3. Vorrichtung nach Anspruch 1 oder 2, wobei
das Suszeptormaterial (5, 105) ebenfalls eine Metallschmelze ist; und/oder
die Metallschmelze (6, 106) und das Suszeptormaterial (5, 105) das gleiche Material oder ein ähnliches Material, insbesondere eines oder entsprechend zwei aus Gallium, Indium oder Aluminium oder Mischungen derselben, umfassen.

4. Vorrichtung nach Anspruch 3, wobei der Inhalt jeweils des ersten Tiegels oder Tiegelbereichs (2, 2a; 26) und des zweiten Tiegels oder Tiegelbereichs (25, 102) über eine Leitung (114) oder eine Öffnung in einer gemeinsamen Trennwand miteinander in Verbindung steht.

5. Vorrichtung nach Anspruch 4, wobei die Verbindung zwischen dem ersten Tiegel oder Tiegelbereich (2, 2a; 26) und dem zweiten Tiegel oder Tiegelbereich (25, 102) nach Art eines Siphons ausgebildet ist.

6. Vorrichtung nach einem der Ansprüche 1 bis 5, wobei der erste Tiegel oder Tiegelbereich (26) zylinder- oder hohlzylinderförmig oder zumindest als ein Segment oder als mehrere entsprechende Segmente ausgebildet ist, und der zweite Tiegel oder Tiegelbereich (25) den ersten Tiegel oder Tiegelbereich (26) zumindest mantelartig umschließt.

7. Vorrichtung nach einem der Ansprüche 1 bis 6, umfassend ein Thermoelement, das in den ersten Tiegel oder Tiegelbereich (2, 2a; 26) zum Erfassen der Temperatur vorgesehen ist; und/oder ein Nachfüllelement, das zum Nachchargieren des Materials der Metallschmelze in dem ersten Tiegel oder Tiegelbereich (2, 2a; 26) oder im Fall des Anspruchs 4 in den ersten oder dem zweiten Tiegel oder Tiegelbereich (25, 102) vorgesehen ist.

8. Vorrichtung nach einem der Ansprüche 1 bis 7, wobei der erste Tiegel oder Tiegelbereich (2, 2a; 26) und/oder der zweite Tiegel oder Tiegelbereich (25, 102) aus einem dielektrischen Material, insbesondere aus pyrolytischem Bornitrid gefertigt sind.

9. Vorrichtung nach Anspruch 6 oder einem der Ansprüche 7 bis 8 soweit rückbezogen auf Anspruch 6, wobei der zylindersymmetrische erste Tiegel oder Tiegelbereich (26) entlang seiner Längsachse den inneren Kanal (28) aufweist, zu welchem hin sich die wenigstens eine Öffnung erstreckt.

10. Vorrichtung nach Anspruch 9, wobei sich der innere Kanal (28) in Strömungsrichtung an seinem Ende trichterförmig öffnet.

11. Verfahren zum Verdampfen von Material aus einer Metallschmelze (6, 106), umfassend:
Bereitstellen eines in einem zweiten Tiegel oder Tiegelbereich (25, 102) vorgesehenen Suszeptormaterials (5);
Zuführen von Wärme durch induktives Heizen des Suszeptormaterials (5, 105);
Bereitstellen der Metallschmelze (6, 106) in einem mit dem zweiten Tiegel oder Tiegelbereich (25, 102) durch thermische Kopplung verbundenen ersten Tiegel oder Tiegelbereich (2, 2a; 26, 103), wobei der erste Tiegel oder Tiegelbereich (2, 2a; 26) einen inneren Kanal (28) umschließt;
Übertragen der Wärme von dem Suszeptormaterial (5, 105) in dem zweiten Tiegel oder Tiegelbereich auf die Metallschmelze (6, 106) in dem ersten Tiegel oder Tiegelbereich (2, 2a; 26, 103) durch thermische Kopplung, so dass die Metallschmelze (6, 106) eine gewünschte Temperatur erreicht;
Verdampfen der Metallschmelze (6, 106) in dem ersten Tiegel oder Tiegelbereich (2, 2a; 26, 103) bei der gewünschten Temperatur unter Abgabe des verdampften Materials aus der Metallschmelze (6) in dem ersten Tiegel oder Tiegelbereich (26) über eine oder mehrere Öff-nungen in den inneren Kanal (28),
Zuführen eines Trägergasstroms (8) in den inneren Kanal (28) zur Mitnahme des verdampften Materials.

12. Verfahren nach Anspruch 11, wobei in den Bereitstellungsschritten die Metallschmelze (6, 106) und das Suszeptormaterial (5, 105) das gleiche Material umfassen.

13. Verfahren nach Anspruch 12, wobei die Metallschmelze (6, 106) und das Suszeptormaterial (5, 105) über eine Öffnung oder eine Leitung (114) zwischen den Tiegeln oder Tiegelbereichen miteinander in Verbindung gebracht werden, so dass der Wärmeübertrag auch durch Konvektion, Diffusion und /oder direkte Wärmeleitung stattfindet.

## Claims

1. Device for evaporating a metal melt (6), comprising:
a first crucible or crucible portion (2, 2a; 26) configured to receive the metal melt (6, 106), comprising at least one aperture, through which the evaporated metal may pass off;
a second crucible or crucible portion (25, 102) configured to receive a susceptor material (5, 105);
a heating source (10), which is arranged such that it heats the susceptor material (5, 105) in the second crucible or crucible portion (25, 102) by means of incident electromagnetic induction, wherein it does not or only negligibly heat the metal melt (6, 106) in the first crucible or crucible portion (2, 2a; 26);
wherein the first crucible or crucible portion (2, 2a; 26) and the second crucible or crucible portion (25, 102) are thermally coupled, such that the metal melt (6, 106) can attain a desired temperature;
wherein the first crucible or crucible portion (2, 2a; 26) comprises an inner channel (28) towards which the at least one aperture extends; wherein there is further provided an arrangement for forming a flow of a carrier gas (8) directed through the channel (28) in order to carry the evaporated metal passed off from the at least one aperture.

2. Device according to claim 1, wherein the first crucible or crucible portion (2, 2a; 26) and the second crucible or crucible portion (25) include a common crucible wall (3).

3. Device according to claim 1 or 2, wherein
the susceptor material (5, 105) also is a metal melt; and/or
the metal melt (6, 106) and the susceptor material (5, 105) include the same or a similar material, in particular one or correspondingly two out of gallium, indium or aluminium, or mixtures of the same.

4. Device according to claim 3, wherein the content of each of the first crucible or crucible portion (2, 2a; 26) and the second crucible or crucible portion (25, 102) are in communication with each other via a conduit (114) or an opening in a common separation wall (17).

5. Device according to claim 4, wherein the connection between the first crucible or crucible portion (2, 2a; 26) and the second crucible or crucible portion (25, 102) is formed in the manner of a siphon.

6. Device according to one of claims 1 through 5, wherein the first crucible or crucible portion (26) is formed substantially cylindrical or at least as one or more corresponding segments, and wherein the second crucible or crucible portion (25) encloses the first crucible or crucible portion (25) at least like a cylinder shell.

7. Device according to one of claims 1 through 6, comprising a thermal element, which is provided in the first crucible or crucible portion (2, 2a; 26) for detecting the temperature; and/or a replenishment element, which is configured to replenish the material of the metal melt in a first crucible or crucible portion (2, 2a; 26) or in the case of claim 4 in the first or second crucible or crucible portion (25, 102).

8. Device according to one of claims 1 through 7, wherein the first crucible or crucible portion (2, 2a; 26) and/or the second crucible or crucible portion (25, 102) is formed from a dielectric material, in particular pyrolytic boron nitride.

9. Device according to claim 6, or one of claims 7 through 8 when depending on claim 6, wherein the cylinder symmetric first crucible or crucible portion (26) comprises the inner channel (28) along its longitudinal axis, towards which the at least one opening extends.

10. Device according to claim 9, wherein the inner channel (28) opens at its one end in the flow direction in the form of a funnel.

11. Method of evaporating a material from a metal melt (6, 106), comprising:
providing a susceptor material (5) in the second crucible or crucible portion (25, 102);
supplying heat by means of inductive heating of the susceptor material (5, 105);
providing the metal melt (6, 106) in a first crucible or crucible portion (2, 2a; 26, 103) being thermally coupled with the second crucible or crucible portion (25, 102), wherein the first crucible or crucible portion (2, 2a; 26) encloses an inner channel (28);
transferring the heat from the susceptor material (5, 105) in the second crucible or crucible portion onto the metal melt (6, 106) in the first crucible or crucible portion (2, 2a; 26, 103) via thermal coupling, such that the metal melt (6, 106) reaches a desired temperature;
evaporating the metal melt (6, 106) in the first crucible or crucible portion (2, 2a; 26, 103) at the desired temperature including the dispense of the evaporated material from the metal melt (6) in the first crucible or crucible portion (26) via one or more apertures into the inner channel (28);
supplying a flow of a carrier gas (8) into the inner channel (28) for carrying the evaporated material.

12. Method according to claim 11, wherein, in the steps of providing the susceptor material and the metal melt, the metal melt (6, 106) and the susceptor material (5, 105) comprise the same material.

13. Method according to claim 12, wherein the metal melt (6, 106) and the susceptor material (5, 105) are brought into connection with each other via an opening or a conduit (114) between the crucibles or crucible portions, such that the heat transfer is effected also by convection, diffusion and/or direct heat transfer.

## Revendications

1. Dispositif pour la vaporisation d'un métal en fusion (6), comprenant :
un premier creuset ou une première zone de creuset (2, 2a ; 26), prévue pour recevoir le métal en fusion (6, 106), présentant au moins une ouverture par laquelle le métal vaporisé peut s'échapper ;
un deuxième creuset ou une deuxième zone de creuset (25, 102) prévue pour recevoir un matériau suscepteur (5, 105) ;
une source de chauffage (10) disposée de manière à chauffer le matériau suscepteur (5, 105) dans le deuxième creuset ou la deuxième zone de creuset (25, 102) par induction électromagnétique, en ne chauffant par contre pas, ou seulement de manière négligeable, le métal en fusion (6, 106) dans le premier creuset ou la première zone de creuset (2, 2a ; 26) ;
le premier creuset ou la première zone de creuset (2, 2a ; 26) et le deuxième creuset ou la deuxième zone de creuset (25, 102) étant thermiquement couplés, si bien que le métal en fusion (6, 106) peut être porté à température souhaitée,
le premier creuset ou la première zone de creuset (2, 2a ; 26) comportant un canal intérieur (28) vers lequel s'étendent l'ouverture ou les ouvertures ; un dispositif étant en outre prévu pour la formation d'un flux de gaz porteur (8) s'écoulant par le canal (28) pour l'entraînement du métal vaporisé s'échappant de l'ouverture ou des ouvertures.

2. Dispositif selon la revendication 1, où le premier creuset ou la première zone de creuset (2, 2a ; 26) et le deuxième creuset ou la deuxième zone de creuset (25) présentent une paroi de creuset (3) commune.

3. Dispositif selon la revendication 1 ou 2, où
le matériau suscepteur (5, 105) est également un métal en fusion ; et/ou
le métal en fusion (6, 106) et le matériau suscepteur (5, 105) comprennent le même matériau ou des matériaux similaires, en particulier un matériau, ou par conséquent deux matériaux sélectionnés entre le gallium, l'indium ou l'aluminium, ou des mélanges de ceux-ci.

4. Dispositif selon la revendication 3, où les contenus respectifs du premier creuset ou de la première zone de creuset (2, 2a ; 26) et du deuxième creuset ou de la deuxième zone de creuset (25, 102) sont en communication entre eux par une conduite (114) ou une ouverture dans une paroi de séparation commune.

5. Dispositif selon la revendication 4, où la communication entre le premier creuset ou la première zone de creuset (2, 2a ; 26) et le deuxième creuset ou la deuxième zone de creuset (25, 102) est réalisée à la manière d'un siphon.

6. Dispositif selon l'une des revendications 1 à 5, où le premier creuset ou la première zone de creuset (26) sont sensiblement en forme de cylindre ou de cylindre creux ou au moins réalisés comme un segment ou plusieurs segments correspondants, et où le deuxième creuset ou la deuxième zone de creuset (25) entoure le premier creuset ou la première zone de creuset (26) au moins à la manière d'une enveloppe.

7. Dispositif selon l'une des revendications 1 à 6, comprenant un thermo-élément, prévu dans le premier creuset ou la première zone de creuset (2, 2a ; 26) pour la détermination de température ; et/ou un élément de remplissage, prévu pour la recharge du métal en fusion dans le premier creuset ou la première zone de creuset (2, 2a ; 26) ou, dans le cas de la revendication 4, dans le premier ou le deuxième creusets ou zones de creuset (25, 102).

8. Dispositif selon l'une des revendications 1 à 7, où le premier creuset ou la première zone de creuset (2, 2a ; 26) et/ou le deuxième creuset ou la deuxième zone de creuset (25, 102) sont en matériau diélectrique, en particulier en nitrure de bore pyrolytique (pBN).

9. Dispositif selon la revendication 6 ou l'une des revendications 7 à 8 si dépendante de la revendication 6, où le premier creuset ou la première zone de creuset (26) à symétrie de cylindre présente le canal intérieur (28) vers lequel s'étendent l'ouverture ou les ouvertures le long de son axe longitudinal.

10. Dispositif selon la revendication 9, où le canal intérieur (28) s'ouvre en forme d'entonnoir à son extrémité dans la direction d'écoulement.

11. Procédé vaporisation d'un matériau à partir d'un métal en fusion (6, 106), comprenant :
préparation d'un matériau suscepteur (5) prévu dans un deuxième creuset ou une deuxième zone de creuset (25, 102) ;
conduction de chaleur par chauffage par induction du matériau suscepteur (5, 105) ;
préparation du métal en fusion (6, 106) dans un premier creuset ou une première zone de creuset (2, 2a ; 26, 103) relié par couplage thermique au deuxième creuset ou à la deuxième zone de creuset (25, 102), le premier creuset ou la première zone de creuset (2, 2a ; 26) entourant un canal intérieur (28) ;
transmission par couplage thermique de la chaleur du matériau suscepteur (5, 105) dans le deuxième creuset ou la deuxième zone de creuset au métal en fusion (6, 106) dans le premier creuset ou la première zone de creuset (2, 2a ; 26, 103), de manière à porter le métal en fusion (6, 106) à une température souhaitée ;
vaporisation du métal en fusion (6, 106) dans le premier creuset ou la première zone de creuset (2, 2a ; 26, 103) à la température souhaitée, le matériau vaporisé à partir du métal en fusion (6) dans le premier creuset ou la première zone de creuset (26) étant évacué par une ou plusieurs ouverture vers le canal intérieur (28),
amenée d'un flux de gaz porteur (8) dans le canal intérieur (28) pour l'entraînement du matériau vaporisé.

12. Procédé selon la revendication 11, où le métal en fusion (6, 106) et le matériau suscepteur (5, 105) comprennent le même matériau dans les étapes de préparation.

13. Procédé selon la revendication 12, où le métal en fusion (6, 106) et le matériau suscepteur (5, 105) sont mis en communication entre eux par une ouverture ou une conduite (114) entre les creusets ou les zones de creuset, si bien que la transmission de chaleur peut également avoir lieu par convection, diffusion et/ou par transfert thermique direct.
